# EUROPEAN PATENT SPECIFICATION

(11) **EP 4 145 514 B1**
(45) Date of publication and mention of the grant of the patent: **04.11.2026**
(21) Application number: 22151695.8
(22) Date of filing: 15.01.2022
(51) Int. Cl.: H10F 39/00, H10F 39/18

(54) **SOLID-STATE IMAGE SENSOR**
FESTKÖRPERBILDSENSOR
CAPTEUR D'IMAGE À SEMI-CONDUCTEUR

(30) Priority: 03.09.2021 US 202117466297
(43) Date of publication of application: 08.03.2023
(73) Proprietor: VisEra Technologies Company Limited, Hsinchu 300-78 (TW)
(72) Inventor: LI, Ching-Hua, Taoyuan City (TW); TU, Zong-Ru, Zhubei City, Hsinchu County (TW); CHANG, Yu-Chi, Hukou township, Hsinchu County (TW)
(74) Representative: Ter Meer und Partner mbB

(56) References cited:
- WO-A1-2018/173754
- US-A1- 2018 114 814
- US-A1- 2019 148 457
- US-A1- 2019 157 336
- US-A1- 2020 403 025

## Description

### BACKGROUND

### Technical Field

The embodiments of the present disclosure relate to image sensors, and in particular they relate to solid-state image sensors that include nano-structures.

### Description of the Related Art

Solid-state image sensors (e.g., charge-coupled device (CCD) image sensors, complementary metal-oxide semiconductor (CMOS) image sensors, and so on) have been widely used in various image-capturing apparatuses such as digital still-image cameras, digital video cameras, and the like. The light sensing portion in the solid-state image sensor may be formed at each of pixels, and signal electric charges may be generated according to the amount of light received in the light sensing portion. In addition, the signal electric charges generated in the light sensing portion may be transmitted and amplified, whereby an image signal is obtained.

An organic photoelectric conversion film may be formed in some solid-state image sensors. However, a thicker organic photoelectric conversion film would be needed to improve the photoelectric conversion efficiency of the organic photoelectric conversion film.

US 2019/148457 A1 discloses an image sensor and method of fabricating thereof. A color filter is disposed on a substrate. An organic photodiode is disposed on the color filter. The organic photodiode includes an electrode insulating layer having a recess region on the substrate, a first electrode on the color filter, the first electrode filling the recess region of the electrode insulating layer, a second electrode on the first electrode, and an organic photoelectric conversion layer interposed between the first electrode and the second electrode. The first electrode includes a seam extending at a first angle from a side surface of the recess region of the electrode insulating layer.

US 2019/157336 A1 discloses an image sensor including splitter. The image sensor includes a plurality of photo diodes disposed at a semiconductor substrate, and a splitter disposed on the photo diodes. The splitter splits an incident light depending on a wavelength so that split light of different colors enters different photo diodes, respectively. The splitter includes a first pattern structure having a cross-sectional structure in which a plurality of refractive layer patterns are deposited in a lateral direction.

WO 2018/173754 A1 presents a multilayer imaging element that is configured from a polarizer and a plurality of layered photoelectric conversion units. The polarizer and the plurality of photoelectric conversion units are layered in a state with the polarizer arranged farther to the light incident side than the plurality of photoelectric conversion units.

US 2018/114814 A1 presents a photoelectric device that includes a first electrode and a second electrode facing each other, a photoelectric conversion layer between the first electrode and the second electrode and including a light absorbing material configured to selectively absorb first visible light including one of visible light in a blue wavelength region of greater than or equal to about 380 nm and less than about 500 nm, visible light in a green wavelength region of about 500 nm to about 600 nm, and visible light in a red wavelength region of greater than about 600 nm and less than or equal to about 700 nm, and a plurality of nanostructures between the first electrode and the photoelectric conversion layer and configured to selectively reflect the first visible light.

### BRIEF SUMMARY

The object of the present invention is solved by the invention defined by the features of the independent claim. Preferred embodiments are given in the dependent claims.

In the present invention, the solid-state image sensor includes nano-structures disposed on the upper side and/or the lower side of the organic film (e.g., organic photoelectric conversion film), which may effectively enhance the photoelectric conversion efficiency, thereby improving the quality of the image signal from the photoelectric conversion elements of the solid-state image sensors.

In accordance with the present invention, a solid-state image sensor is provided. The solid-state image sensor includes a semiconductor substrate having photoelectric conversion elements. The solid-state image sensor also includes an isolation structure disposed between the photoelectric conversion elements. The solid-state image sensor further includes a color filter layer disposed above the semiconductor substrate and having color filter segments that correspond to the photoelectric conversion elements. Moreover, the solid-state image sensor includes an organic film disposed above the color filter layer. The solid-state image sensor also includes an upper electrode and a lower electrode respectively disposed on the upper side and the lower side of the organic film. The solid-state image sensor further includes nano-structures disposed on the upper side or the lower side of the organic film.

According to the invention, the organic film has organic segments.

In some embodiments, the solid-state image sensor may further include a grid structure disposed between the color filter segments.

In some embodiments, the refractive index of the grid structure may be lower than the refractive index of the color filter layer.

In some embodiments, the grid structure may be also disposed between the organic segments.

In some embodiments, the refractive index of the grid structure may be lower than the refractive index of the organic film.

In some embodiments, the isolation structure may be also disposed between the color filter segments.

In some embodiments, the isolation structure may be further disposed between the organic segments.

According to the invention, the length of the nano-structures in each organic segment is between 200 µm and 500 µm.

According to the invention, the nano-structures are disposed inside the organic film.

In some embodiments, the nano-structures may be disposed on the upper side of the upper electrode.

In some embodiments, the lower electrode may have electrode segments that correspond to the photoelectric conversion elements.

In some embodiments, one of the electrode segments may include a first electrode segment and a second electrode segment that correspond to one color filter segment.

In some embodiments, the length of the first electrode segment may be different from the length of the second electrode segment.

The organic film has organic segments.

The first electrode segment and the second electrode segment may be disposed on the lower side of a specific organic segment of the organic segments.

In some embodiments, the length of the nano-structures in the specific organic segment may correspond to the length of the first electrode segment.

In some embodiments, the nano-structures may be a portion of the upper electrode or the lower electrode.

In some embodiments, each nano-structure may be formed into a triangular pyramid, a cone, or a quadrangular pyramid.

In some embodiments, the nano-structures may include a transparent conductive material or a metal.

In some embodiments, the solid-state image sensor may include a condensing structure disposed on the organic film, and the condensing structure includes micro-lenses that correspond to the color filter segments.

### BRIEF DESCRIPTION OF THE DRAWINGS

The disclosure can be more fully understood from the following detailed description when read with the accompanying figures. It is worth noting that, in accordance with standard practice in the industry, various features are not drawn to scale. In fact, the dimensions of the various features may be arbitrarily increased or reduced for clarity of discussion.
FIG. 1 is a cross-sectional view illustrating a portion of the solid-state image sensor in accordance with some embodiments of the present disclosure.
FIG. 2 is a cross-sectional view illustrating a portion of the solid-state image sensor in accordance with some embodiments of the present disclosure.
FIG. 3 is a cross-sectional view illustrating a portion of the solid-state image sensor in accordance with some embodiments of the present disclosure.
FIG. 4 is a cross-sectional view illustrating a portion of the solid-state image sensor in accordance with some embodiments of the present disclosure.
FIG. 5 is a cross-sectional view illustrating a portion of the solid-state image sensor in accordance with some embodiments of the present disclosure.
FIG. 6 is a cross-sectional view illustrating a portion of the solid-state image sensor in accordance with some embodiments of the present disclosure.
FIG. 7A, FIG. 7B, and FIG.7C are different examples of the nano-structures.

### DETAILED DESCRIPTION

The following disclosure provides many different embodiments, or examples, for implementing different features of the subject matter provided. Specific examples of components and arrangements are described below to simplify the present disclosure. These are, of course, merely examples and are not intended to be limiting. For example, a first feature is formed on a second feature in the description that follows may include embodiments in which the first feature and second feature are formed in direct contact, and may also include embodiments in which additional features may be formed between the first feature and second feature, so that the first feature and second feature may not be in direct contact.

It should be understood that additional steps may be implemented before, during, or after the illustrated methods, and some steps might be replaced or omitted in other embodiments of the illustrated methods.

Furthermore, spatially relative terms, such as "beneath," "below," "lower," "on," "above," "upper" and the like, may be used herein for ease of description to describe one element or feature's relationship to other elements or features as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

In the present disclosure, the terms "about," "approximately" and "substantially" typically mean +/-20% of the stated value, more typically +/-10% of the stated value, more typically +/-5% of the stated value, more typically +/-3% of the stated value, more typically +/-2% of the stated value, more typically +/-1% of the stated value and even more typically +/-0.5% of the stated value. The stated value of the present disclosure is an approximate value. That is, when there is no specific description of the terms "about," "approximately" and "substantially", the stated value includes the meaning of "about," "approximately" or "substantially".

Unless otherwise defined, all terms (including technical and scientific terms) used herein have the same meaning as commonly understood by one of ordinary skill in the art to which this disclosure belongs. It should be understood that terms such as those defined in commonly used dictionaries should be interpreted as having a meaning that is consistent with their meaning in the context of the relevant art and will not be interpreted in an idealized or overly formal sense unless expressly so defined in the embodiments of the present disclosure.

The present disclosure may repeat reference numerals and/or letters in following embodiments. This repetition is for the purpose of simplicity and clarity and does not in itself dictate a relationship between the various embodiments and/or configurations discussed.

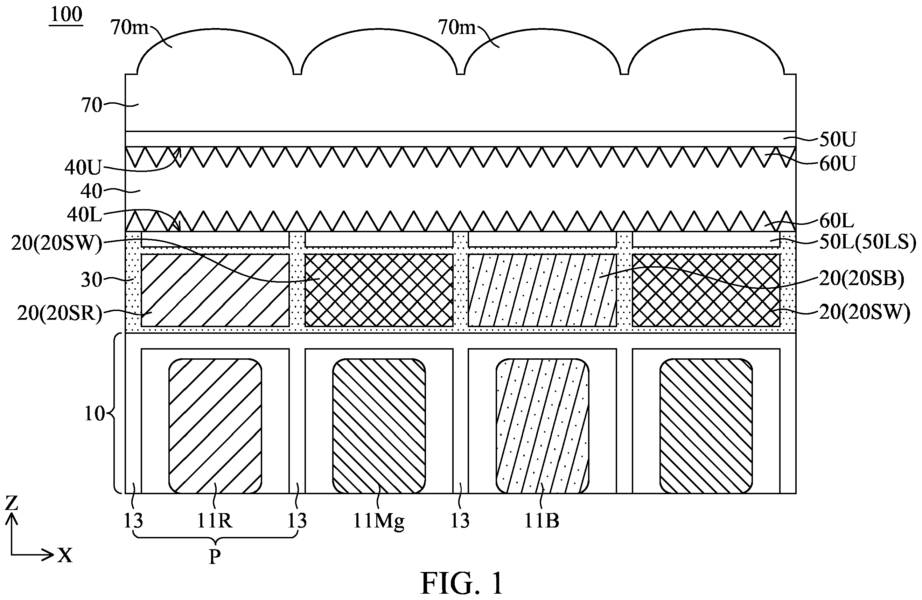

FIG. 1 is a cross-sectional view illustrating a portion of the solid-state image sensor 100 in accordance with some embodiments of the present disclosure. It should be noted that some components of the solid-state image sensor 100 have been omitted in FIG. 1 for the sake of brevity.

Referring to FIG. 1, in embodiments of the invention, the solid-state image sensor 100 includes a semiconductor substrate 10. The semiconductor substrate 10 may be a wafer or a chip. For example, the semiconductor substrate 10 may include silicon, but the present disclosure is not limited thereto. In the embodiments, the semiconductor substrate 10 has a plurality of photoelectric conversion elements, and each photoelectric conversion element may correspond to one (normal) pixel P, but the present disclosure is not limited thereto.

For example, the semiconductor substrate 10 has a photoelectric conversion element 11R that may be used for receiving red light, a photoelectric conversion element 11Mg that may be used for receiving magenta light, and a photoelectric conversion element 11B that may be used for receiving blue light as shown in FIG. 1, but the present disclosure is not limited thereto. The semiconductor substrate 10 may have other photoelectric conversion elements that may be used for receiving, for example, green light, yellow light, white light, cyan light, or IR/NIR, which may be adjusted depending on actual needs.

Referring to FIG. 1, in embodiments of the invention, the solid-state image sensor 100 includes an isolation structure 13 disposed between the photoelectric conversion elements. As shown in FIG. 1, the isolation structure 13 may be disposed between the photoelectric conversion element 11R and the photoelectric conversion element 11Mg, and between the photoelectric conversion element 11Mg and the photoelectric conversion element 11B. For example, the isolation structure 13 may include a shallow trench isolation (STI) or a deep trench isolations (DTI). The isolation structure 13 may be formed in the semiconductor substrate 10 using etching process to form trenches and filling the trenches with an insulating or dielectric material, but the present disclosure is not limited thereto.

As shown in FIG. 1, the isolation structure 13 may separate the photoelectric conversion elements. That is, the photoelectric conversion elements (e.g., 11R, 11Mg, or 11B) in the semiconductor substrate 10 may be isolated from each other by the isolation structure 13, but the present disclosure is not limited thereto.

Referring to FIG. 1, in embodiments of the invention, the solid-state image sensor 100 includes a color filter layer 20 disposed above the semiconductor substrate 10. In embodiments of the invention, the color filter layer 20 has (or is divided into) color filter segments that correspond to the photoelectric conversion elements. For example, as shown in FIG. 1, the color filter layer 20 may have a red color filter segment 20SR that corresponds to the photoelectric conversion element 11R, a white color filter segment 20SW that corresponds to the photoelectric conversion element 11Mg (there are two white color filter segments 20SW and two photoelectric conversion elements 11Mg shown in FIG. 1), and a blue color filter segment 20SB that corresponds to the photoelectric conversion element 11B, but the present disclosure is not limited thereto.

In some other embodiments, the color filter layer 20 has (or is divided into) other color filter segments. For example, the color filter layer 20 may have a green color filter segment, a yellow color filter segment, a white color filter segment, a cyan color filter segment, a magenta color filter segment, or an IR/NIR color filter segment, but the present disclosure is not limited thereto.

As shown in FIG. 1, in some embodiments, the solid-state image sensor 100 includes a grid structure 30 disposed between the color filter segments. For example, as shown in FIG. 1, the grid structure 30 may be disposed between the red color filter segment 20SR and the white color filter segment 20SW, and between the white color filter segment 20SW and the blue color filter segment 20SB, but the present disclosure is not limited thereto. The grid structure 30 may include a transparent dielectric material that has a low refractive index in a range from about 1.0 to about 1.99. In some embodiments, the refractive index of the grid structure 30 is lower than the refractive index of the color filter layer 20 (that includes red color filter segment 20SR, white color filter segment 20SW, blue color filter segment 20SB, and so on).

The grid structure 30 may be formed by depositing a dielectric layer on the semiconductor substrate 10 and then patterning the dielectric layer using photolithography and etching processes, but the present disclosure is not limited thereto.

Referring to FIG. 1, in embodiments of the invention, the solid-state image sensor 100 includes an organic film 40 disposed above the color filter layer 20. The organic film 40 may be used as an organic photoelectric conversion film, and the organic film 40 may include polycyclic aromatic hydrocarbons (PAH or PAHs), phthalocyanine, the like, or a combination thereof, but the present disclosure is not limited thereto.

Referring to FIG. 1, in embodiments of the invention, the solid-state image sensor 100 includes an upper electrode 50U and a lower electrode 50L respectively disposed on the upper side 40U and the lower side 40L of the organic film 40. The upper electrode 50U and the lower electrode 50L may include a transparent conductive material. For example, the transparent conductive material may include indium tin oxide (ITO), tin oxide (TO), indium zinc oxide (IZO), indium gallium zinc oxide (IGZO), indium zinc tin oxide (ITZO), antimony tin oxide (ATO), or antimony zinc oxide (AZO), but the present disclosure is not limited thereto. As shown in FIG. 1, in some embodiments, the lower electrode 50L has (or is divided into) electrode segments 50LS that correspond to the photoelectric conversion elements (e.g., 11R, 11Mg, or 11B).

The upper electrode 50U and the lower electrode 50L may be disposed on the upper side 40U and the lower side 40L of the organic film 40 by a deposition process and/or a photolithography process, but the present disclosure is not limited thereto.

Referring to FIG. 1, in some embodiments of the invention, the solid-state image sensor 100 includes nano-structures 60U disposed on the upper side 40U of the organic film 40 and nano-structures 60L disposed on the lower side 40L of the organic film 40. That is, the nano-structures (60U or 60L) are disposed inside the organic film 40 and disposed on both sides of the organic film 40. In embodiments of the invention, the nano-structures (60U or 60L) are disposed on the upper side 40U and/or the lower side 40L of the organic film 40. That is, the nano-structures (60U or 60L) may be disposed on only one side of the organic film 40.

In some embodiments, the nano-structures 60U and 60L include a transparent conductive material that is the same as or similar to the upper electrode 50U and the lower electrode 50L. In some embodiments, the nano-structures 60U and 60L are a portion of the upper electrode 50U and the lower electrode 50L. For example, a surface roughening treatment may be performed on the upper electrode 50U or the lower electrode 50L to form nano-structures 60U or 60L, but the present disclosure is not limited thereto. In some other embodiments, the nano-structures 60U and 60L include a metal. For example, the metal may include gold (Au), nickel (Ni), platinum (Pt), palladium (Pd), iridium (Ir), titanium (Ti), chromium (Cr), tungsten (W), aluminum (Al), copper (Cu), the like, an alloy thereof, or a combination thereof, but the present disclosure is not limited thereto.

As shown in FIG. 1, in some embodiments, the solid-state image sensor 100 includes a condensing structure 70 disposed on the organic film 40 for condensing incident light. The condensing structure 70 may include glass, epoxy resin, silicone resin, polyurethane, any other applicable material, or a combination thereof, but the present disclosure is not limited thereto. For example, the condensing structure 70 may be formed by a photoresist reflow method, a hot embossing method, any other applicable method, or a combination thereof. Moreover, the steps of forming the condensing structure 70 may include a spin coating process, a lithography process, an etching process, any other applicable process, or a combination thereof, but the present disclosure is not limited thereto.

As shown in FIG. 1, in some embodiments, the condensing structure 70 includes micro-lenses 70m that correspond to the color filter segments (e.g., 20SR, 20SW, or 20SB). In other words, micro-lenses 70m may also correspond to the photoelectric conversion elements (e.g., 11R, 11Mg, or 11B), but the present disclosure is not limited thereto. In some embodiments, the micro-lenses 70m are formed as an m×n array, wherein m and n are positive integers.

In the embodiment shown in FIG. 1, each micro-lens 70m corresponds to one color filter segment and/or one photoelectric conversion element, but the present disclosure is not limited thereto. In some other embodiments, each micro-lens 70m corresponds to at least two (i.e., two or more) color filter segments and/or at least two (i.e., two or more) photoelectric conversion elements. That is, the number of micro-lenses 70m is not limited to the embodiment shown in FIG. 1, which may be adjusted depending on actual needs.

The micro-lens 70m may include a semi-convex lens or a convex lens, but the present disclosure is not limited thereto. The condensing structure 70 may also include micro-pyramid structures (e.g., circular cone, quadrangular pyramid, and so on), or micro-trapezoidal structures (e.g., flat top cone, truncated square pyramid, and so on). Alternatively, the condensing structure 70 may be a gradient-index structure.

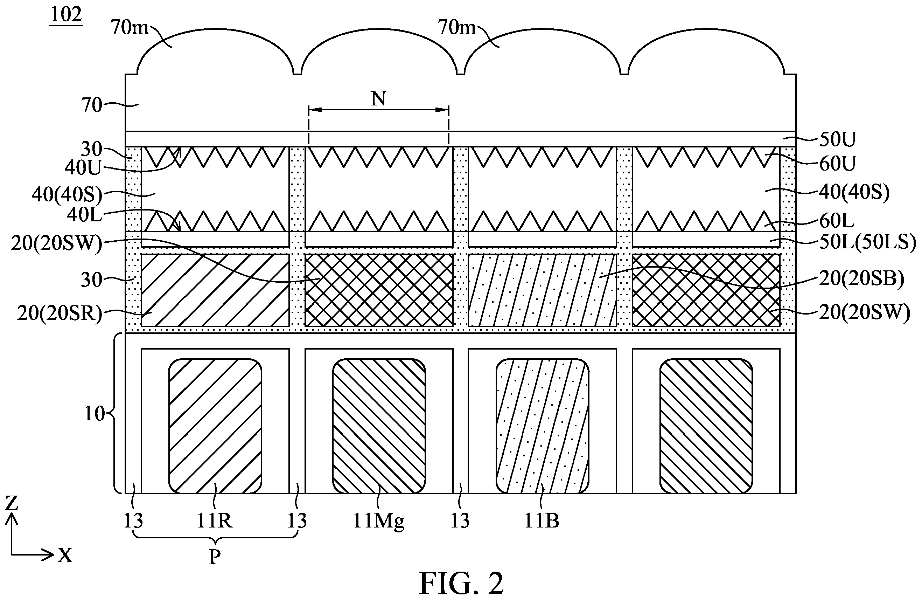

FIG. 2 is a cross-sectional view illustrating a portion of the solid-state image sensor 102 in accordance with some embodiments of the present disclosure. Similarly, some components of the solid-state image sensor 102 have been omitted in FIG. 2 for the sake of brevity.

The solid-state image sensor 102 shown in FIG. 2 has a similar structure to the solid-state image sensor 100 shown in FIG. 1. The main difference from the solid-state image sensor 100 shown in FIG. 1 is that the organic film 40 of the solid-state image sensor 102 shown in FIG. 2 has (or is divided into) organic segments 40S. In more detail, in some embodiments, the grid structure 30 is also disposed between the organic segments 40S. In other word, the grid structure 30 may extend from the color filter layer 20 into the organic film 40, so that the organic film 40 may be divided into organic segments 40S by the grid structure 30, but the present disclosure is not limited thereto.

In some embodiments, the refractive index of the grid structure 30 is lower than the refractive index of the organic film 40 (or the organic segments 40S). As shown in FIG. 2, the length N of the nano-structures in each organic segment 40S may be the same. In embodiments of the invention, the length N of the nano-structures in each organic segment 40S is between about 200 µm and about 500 µm.

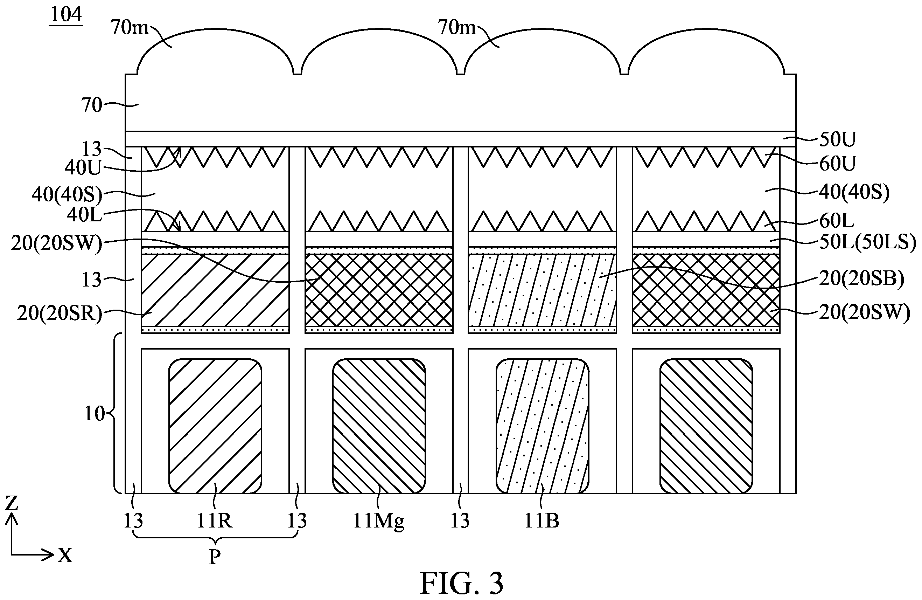

FIG. 3 is a cross-sectional view illustrating a portion of the solid-state image sensor 104 in accordance with some embodiments of the present disclosure. Similarly, some components of the solid-state image sensor 104 have been omitted in FIG. 3 for the sake of brevity.

The solid-state image sensor 104 shown in FIG. 3 has a similar structure to the solid-state image sensor 100 shown in FIG. 1. The main difference from the solid-state image sensor 100 shown in FIG. 1 is that the isolation structure 13 replaces the grid structure 30 and is disposed between the color filter segments (e.g., 20SR, 20SW, and 20SB) in solid-state image sensor 104 shown in FIG. 3.

Moreover, the organic film 40 of the solid-state image sensor 104 shown in FIG. 3 has (or is divided into) organic segments 40S. In some embodiments, the isolation structure 13 is also disposed between the organic segments 40S. In other word, the isolation structure 13 may extend from the substrate 10 into the color filter layer 20 and the organic film 40, so that the color filter layer 20 may be divided into color filter segments (e.g., 20SR, 20SW, or 20SB) by the isolation structure 13, and the organic film 40 may be divided into organic segments 40S by the isolation structure 13, but the present disclosure is not limited thereto.

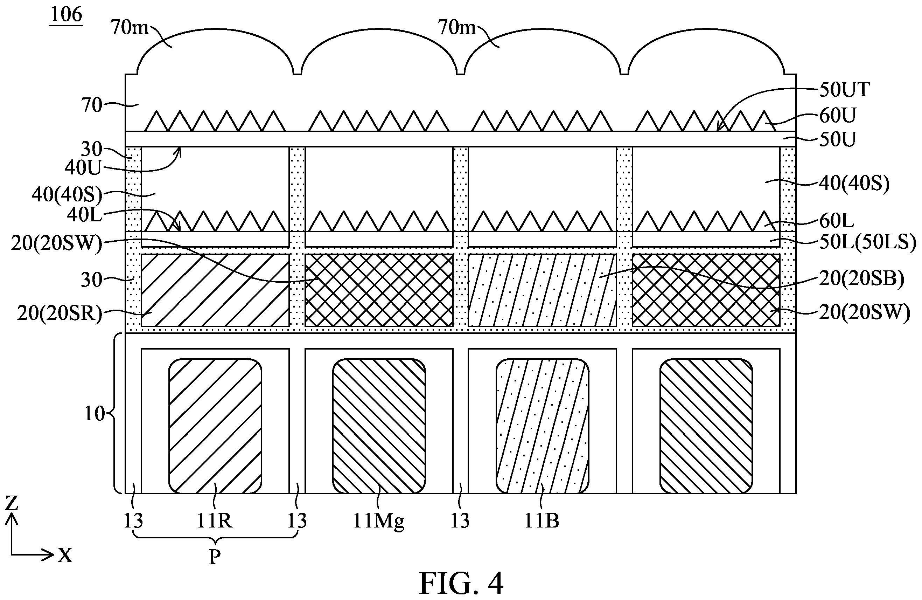

FIG. 4 is a cross-sectional view illustrating a portion of the solid-state image sensor 106 in accordance with some embodiments of the present disclosure. Similarly, some components of the solid-state image sensor 106 have been omitted in FIG. 4 for the sake of brevity.

The solid-state image sensor 106 shown in FIG. 4 has a similar structure to the solid-state image sensor 102 shown in FIG. 2. The main difference from the solid-state image sensor 102 shown in FIG. 2 is that the nano-structures 60U of the solid-state image sensor 106 shown in FIG. 4 are disposed on the upper side 50UT of the upper electrode 50. In other word, some nano-structures (e.g., 60U) may be disposed outside the organic film 40.

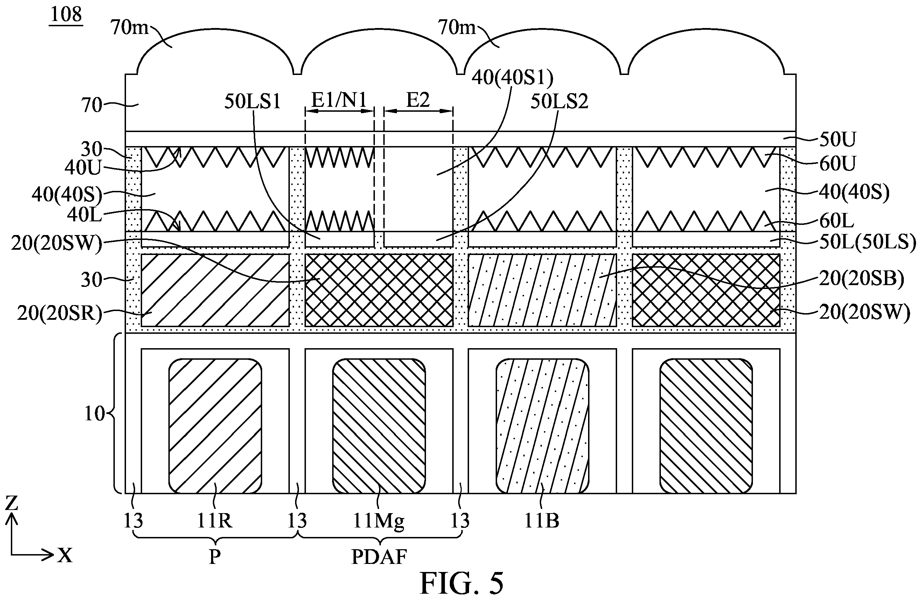

FIG. 5 is a cross-sectional view illustrating a portion of the solid-state image sensor 108 in accordance with some embodiments of the present disclosure. Similarly, some components of the solid-state image sensor 108 have been omitted in FIG. 5 for the sake of brevity.

The solid-state image sensor 108 shown in FIG. 5 has a similar structure to the solid-state image sensor 102 shown in FIG. 2. The main difference from the solid-state image sensor 102 shown in FIG. 2 is that one electrode segment 50LS of the lower electrode 50L in the solid-state image sensor 108 shown in FIG. 5 includes (or is divided into) a first electrode segment 50LS1 and a second electrode segment 50LS2.

In the embodiment shown in FIG. 5, the first electrode segment 50LS1 and the second electrode segment 50LS2 correspond to the white color filter segment 20SW, but the present disclosure is not limited thereto. In some other embodiments, the first electrode segment 50LS1 and the second electrode segment 50LS2 correspond to the red color filter segment 20SR, the blue color filter segment 20SB, or any other color filter segment. Moreover, there may be more than one electrode segment 50LS of the lower electrode 50L that include (or are divided into) the first electrode segment 50LS1 and the second electrode segment 50LS2. In some embodiments, the first electrode segment 50LS1 and the second electrode segment 50LS2 and the corresponding photoelectric conversion element 11Mg may be used to correspond to one phase detection auto focus (PDAF) pixel (which is labeled as PDAF in FIG. 5).

As shown in FIG. 5, in some embodiments, the first electrode segment 50LS1 and the second electrode segment 50LS2 are disposed on the lower side 40L of the organic segment 40S1. In the embodiment shown in FIG. 5, the length E1 of the first electrode segment 50LS1 is equal to the length E2 of the second electrode segment 50LS2. Moreover, in some embodiments, the length N1 of the nano-structures 60U or 60L in the organic segment 40S1 corresponds to the length E1 of the first electrode segment 50LS1. For example, the length N1 of the nano-structures 60U or 60L in the organic segment 40S1 may be equal to the length E1 of the first electrode segment 50LS1, but the present disclosure is not limited thereto.

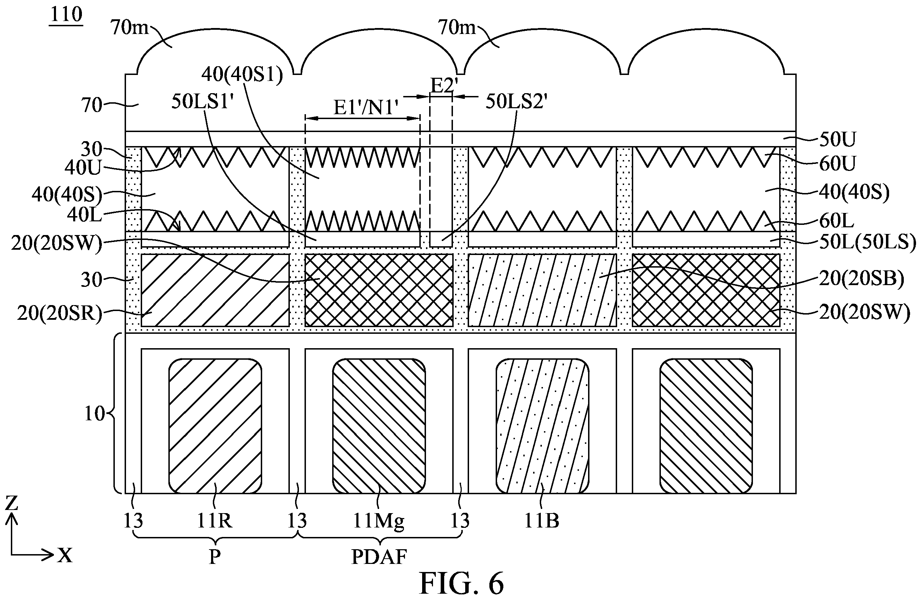

FIG. 6 is a cross-sectional view illustrating a portion of the solid-state image sensor 110 in accordance with some embodiments of the present disclosure. Similarly, some components of the solid-state image sensor 110 have been omitted in FIG. 6 for the sake of brevity.

The solid-state image sensor 110 shown in FIG. 6 has a similar structure to the solid-state image sensor 108 shown in FIG. 5. The main difference from the solid-state image sensor 108 shown in FIG. 5 is that the length E1' of the first electrode segment 50LS1' is different from the length E2' of the second electrode segment 50LS2' in the solid-state image sensor 110 shown in FIG. 6. In more detail, the length E1' of the first electrode segment 50LS1' may be greater than the length E2' of the second electrode segment 50LS2', but the present disclosure is not limited thereto. Similarly, in some embodiments, the length N1' of the nano-structures 60U or 60L in the organic segment 40S1 corresponds to the length E1' of the first electrode segment 50LS1'. For example, the length N1' of the nano-structures 60U or 60L in the organic segment 40S1 may be equal to the length E1' of the first electrode segment 50LS1', but the present disclosure is not limited thereto.

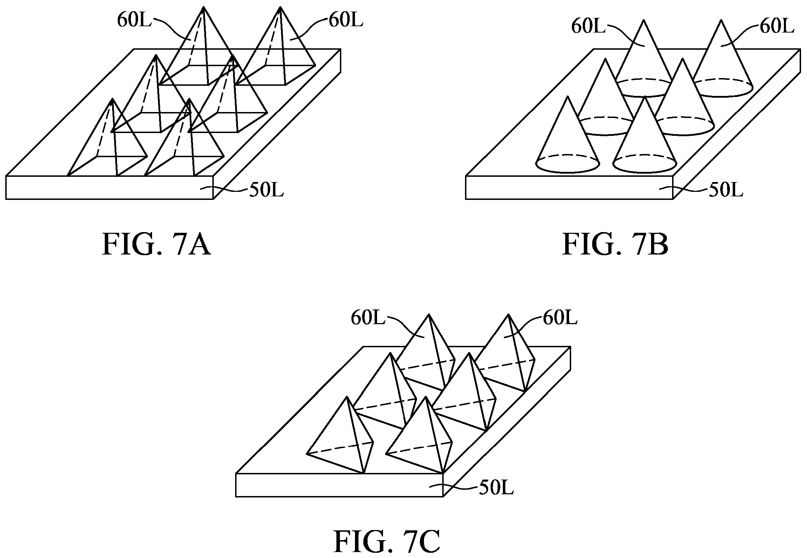

FIG. 7A, FIG. 7B, and FIG.7C are different examples of the nano-structures 60L. It should be noted that the nano-structures 60U may have a shape the same as or similar to that of the nano-structures 60L. As shown in FIG. 7A, each nano-structure 60L (or 60U) is formed into a quadrangular pyramid. As shown in FIG. 7B, each nano-structure 60L (or 60U) is formed into a cone. As shown in FIG. 7C, each nano-structure 60L (or 60U) is formed into a triangular pyramid. However, the shape of each nano-structure 60L (or 60U) is not limited to the examples shown in FIG. 7A, FIG. 7B, and FIG.7C, which may be adjusted depending on actual needs.

In summary, the solid-state image sensor according to embodiments of the present invention include nano-structures disposed on the upper side and/or the lower side of the organic film (e.g., organic photoelectric conversion film), which may effectively enhance the photoelectric conversion efficiency, thereby improving the quality of the image signal from the photoelectric conversion elements of the solid-state image sensors.

The foregoing outlines features of several embodiments so that those skilled in the art may better understand the aspects of the present disclosure. Those skilled in the art should appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the scope of the present disclosure, and that they may make various changes, substitutions, and alterations herein without departing from the scope of the present disclosure. Therefore, the scope of protection should be determined through the claims. In addition, although some embodiments of the present disclosure are disclosed above, they are not intended to limit the scope of the present disclosure.

Reference throughout this specification to features, advantages, or similar language does not imply that all of the features and advantages that may be realized with the present disclosure should be or are in any single embodiment of the disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same embodiment.

Furthermore, the described features, advantages, and characteristics of the disclosure may be combined in any suitable manner in one or more embodiments. One skilled in the relevant art will recognize, in light of the description herein, that the disclosure can be practiced without one or more of the specific features or advantages of a particular embodiment. In other instances, additional features and advantages may be recognized in certain embodiments that may not be present in all embodiments of the disclosure.

## Claims

1. A solid-state image sensor, comprising:
a semiconductor substrate (10) having photoelectric conversion elements (11R, 11Mg, 11B);
a color filter layer (20) disposed above the semiconductor substrate (10) and having color filter segments (20SR, 20SW, 20SB) corresponding to the photoelectric conversion elements (11R, 11Mg, 11B);
an organic photoelectric conversion film (40) disposed above the color filter layer (20);
an upper electrode (50U) and a lower electrode (50L) respectively disposed on an upper side (40U) and a lower side (40L) of the organic film (40); and
nano-structures (60U, 60L) disposed on the upper side and/or the lower side of the organic photoelectric conversion film (40), wherein the nano-structures (60U, 60L) are disposed inside the organic photoelectric conversion film (40);
**characterized in that**, the solid-state image sensor further comprising:
an isolation structure (13) disposed between the photoelectric conversion elements (11R, 11Mg, 11B); and
the organic photoelectric conversion film (40) has organic segments (40S) corresponding to the colour filter segments, and a length of the nano-structures (60U, 60L) in each of the organic segments (40S) is between 200 µm and 500 µm.

2. The solid-state image sensor as claimed in claim 1, further comprising a grid structure (30) disposed between the color filter segments (20SR, 20SW, 20SB), preferably a refractive index of the grid structure (30) is lower than a refractive index of the color filter layer (20).

3. The solid-state image sensor as claimed in claim 2, wherein the grid structure (30) is also disposed between the organic segments (40S), and a refractive index of the grid structure (30) is lower than a refractive index of the organic photoelectric conversion film (40).

4. The solid-state image sensor as claimed in claim 1, wherein the isolation structure (13) is also disposed between the color filter segments (20SR, 20SW, or 20SB), and the isolation structure (13) is further disposed between the organic segments (40S).

5. The solid-state image sensor as claimed in any one of the preceding claims, wherein the nano-structures (60U) are disposed on an upper side of the upper electrode (50U).

6. The solid-state image sensor as claimed in any one of the preceding claims, wherein the lower electrode (50L) has electrode segments (50LS) corresponding to the photoelectric conversion elements (11R, 11Mg, 11B), and/or one of the electrode segments (50LS) comprises a first electrode segment (50LS1) and a second electrode segment (50LS2) that correspond to one of the color filter segments (20SR, 20SW, or 20SB).

7. The solid-state image sensor as claimed in claim 6, wherein a length of the first electrode segment (50LS1) is different from a length of the second electrode segment (50LS2).

8. The solid-state image sensor as claimed in claim 6 or 7, wherein the organic photoelectric conversion film (40) has organic segments (40S), and the first electrode segment (50LS1) and the second electrode segment (50LS2) are disposed on a lower side of a specific organic segment of the organic segments (40S).

9. The solid-state image sensor as claimed in claim 8, wherein a length of the nano-structures (60U, 60L) in the specific organic segment corresponds to a length of the first electrode segment (50LS1).

10. The solid-state image sensor as claimed in any one of the preceding claims, wherein the nano-structures (60U, 60L) are a portion of the upper electrode (50U) or the lower electrode (50L).

11. The solid-state image sensor as claimed in any one of the preceding claims, wherein each of the nano-structures (60U, 60L) is formed into one of a triangular pyramid, a cone, and a quadrangular pyramid.

12. The solid-state image sensor as claimed in any one of the preceding claims, wherein the nano-structures (60U, 60L) comprise a transparent conductive material or a metal.

13. The solid-state image sensor as claimed in any one of the preceding claims, further comprising a condensing structure (70) disposed on the organic photoelectric conversion film (40), wherein the condensing structure (70) comprises micro-lenses (70m) that correspond to the color filter segments (20SR, 20SW, or 20SB).

## Patentansprüche

1. Festkörperbildsensor, der umfasst:
ein Halbleitersubstrat (10) mit fotoelektrischen Umsetzungselementen (11R, 11Mg, 11B);
eine Farbfilterschicht (20), die über dem Halbleitersubstrat (10) angeordnet ist und Farbfiltersegmente (20SR, 20SW, 20SB) besitzt, die den fotoelektrischen Umsetzungselementen (11R, 11Mg, 11B) entsprechen;
eine organische fotoelektrische Umsetzungsschicht (40), die über der Farbfilterschicht (20) angeordnet ist;
eine obere Elektrode (50U) und eine untere Elektrode (50L), die auf einer oberen Seite (40U) bzw. einer unteren Seite (40L) der organischen Schicht (40) angeordnet sind; und
Nanostrukturen (60U, 60L), die auf der oberen Seite und/oder der unteren Seite der organischen fotoelektrischen Umsetzungsschicht (40) angeordnet sind, wobei die Nanostrukturen (60U, 60L) innerhalb der organischen fotoelektrischen Umsetzungsschicht (40) angeordnet sind;
**dadurch gekennzeichnet, dass** der Festkörperbildsensor ferner umfasst:
eine Isolierstruktur (13), die zwischen den fotoelektrischen Umsetzungselementen (11R, 11Mg, 11B) angeordnet ist; und
wobei die organische fotoelektrische Umsetzungsschicht (40) organische Segmente (40S) besitzt, die den Farbfiltersegmenten entsprechen, und eine Länge der Nanostrukturen (60U, 60L) in jedem der organischen Segmente (40S) zwischen 200 µm und 500 µm beträgt.

2. Festkörperbildsensor nach Anspruch 1, der ferner eine Gitterstruktur (30) umfasst, die zwischen den Farbfiltersegmenten (20SR, 20SW, 20SB) angeordnet ist, wobei ein Brechungsindex der Gitterstruktur (30) vorzugsweise niedriger als ein Brechungsindex der Farbfilterschicht (20) ist.

3. Festkörperbildsensor nach Anspruch 2, wobei die Gitterstruktur (30) außerdem zwischen den organischen Segmenten (40S) angeordnet ist und ein Brechungsindex der Gitterstruktur (30) niedriger als ein Brechungsindex der organischen fotoelektrischen Umsetzungsschicht (40) ist.

4. Festkörperbildsensor nach Anspruch 1, wobei die Isolierstruktur (13) außerdem zwischen den Farbfiltersegmenten (20SR, 20SW oder 20SB) angeordnet ist und die Isolierstruktur (13) ferner zwischen den organischen Segmenten (40S) angeordnet ist.

5. Festkörperbildsensor nach einem der vorhergehenden Ansprüche, wobei die Nanostrukturen (60U) auf einer oberen Seite der oberen Elektrode (50U) angeordnet sind.

6. Festkörperbildsensor nach einem der vorhergehenden Ansprüche, wobei die untere Elektrode (50L) Elektrodensegmente (50LS) besitzt, die den fotoelektrischen Umsetzungselementen (11R, 11Mg, 11B) entsprechen, und/oder eines der Elektrodensegmente (50LS) ein erstes Elektrodensegment (50LS1) und ein zweites Elektrodensegment (50LS2), die einem der Farbfiltersegmente (20SR, 20SW oder 20 SB) entsprechen, umfasst.

7. Festkörperbildsensor nach Anspruch 6, wobei eine Länge des ersten Elektrodensegments (50LS1) von einer Länge des zweiten Elektrodensegments (50LS2) verschieden ist.

8. Festkörperbildsensor nach Anspruch 6 oder 7, wobei die organische fotoelektrische Umsetzungsschicht (40) organische Segmente (40S) besitzt und das erste Elektrodensegment (50LS1) und das zweite Elektrodensegment (50LS2) auf einer unteren Seite eines spezifischen organischen Segments der organischen Segmente (40S) angeordnet sind.

9. Festkörperbildsensor nach Anspruch 8, wobei eine Länge der Nanostrukturen (60U, 60L) in dem spezifischen organischen Segment einer Länge des ersten Elektrodensegments (50LS1) entspricht.

10. Festkörperbildsensor nach einem der vorhergehenden Ansprüche, wobei die Nanostrukturen (60U, 60L) ein Teil der oberen Elektrode (50U) oder der unteren Elektrode (50L) sind.

11. Festkörperbildsensor nach einem der vorhergehenden Ansprüche, wobei jede der Nanostrukturen (60U, 60L) in eine dreiseitige Pyramide oder einen Kegel oder eine vierseitige Pyramide geformt ist.

12. Festkörperbildsensor nach einem der vorhergehenden Ansprüche, wobei die Nanostrukturen (60U, 60L) ein transparentes leitendes Material oder ein Metall umfassen.

13. Festkörperbildsensor nach einem der vorhergehenden Ansprüche, der ferner eine bündelnde Struktur (70) umfasst, die auf der organischen fotoelektrischen Umsetzungsschicht (40) angeordnet ist, wobei die bündelnde Struktur (70) Mikrolinsen (70m) umfasst, die den Farbfiltersegmenten (20SR, 20SW oder 20 SB) entsprechen.

## Revendications

1. Capteur d'image à semi-conducteur, comportant :
un substrat semi-conducteur (10) ayant des éléments de conversion photoélectrique (11R, 11Mg, 11B) ;
une couche de filtre à couleur (20) disposée au-dessus du substrat semi-conducteur (10) et ayant des segments de filtre à couleur (20SR, 20SW, 20SB) correspondant aux éléments de conversion photoélectrique (11R, 11Mg, 11B) ;
un film de conversion photoélectrique organique (40) disposé au-dessus de la couche de filtre à couleur (20) ;
une électrode supérieure (50U) et une électrode inférieure (50L) disposées respectivement sur une face supérieure (40U) et une face inférieure (40L) du film organique (40) ; et
des nanostructures (60U, 60L) disposées sur la face supérieure et/ou la face inférieure du film de conversion photoélectrique organique (40), dans lequel les nanostructures (60U, 60L) sont disposées à l'intérieur du film de conversion photoélectrique organique (40) ;
**caractérisé en ce que** le capteur d'image à semi-conducteur comporte en outre :
une structure d'isolation (13) disposée entre les éléments de conversion photoélectrique (11R, 11Mg, 11B) ; et
le film de conversion photoélectrique organique (40) a des segments organiques (40S) correspondant aux segments de filtre à couleur, et une longueur des nanostructures (60U, 60L) dans chacun des segments organiques (40S) est comprise entre 200 µm et 500 µm.

2. Capteur d'image à semi-conducteur selon la revendication 1, comportant en outre une structure en grille (30) disposée entre les segments de filtre à couleur (20SR, 20SW, 20SB), un indice de réfraction de la structure en grille (30) étant de préférence inférieur à un indice de réfraction de la couche de filtre à couleur (20).

3. Capteur d'image à semi-conducteur selon la revendication 2, dans lequel la structure en grille (30) est également disposée entre les segments organiques (40S), et un indice de réfraction de la structure en grille (30) est inférieur à un indice de réfraction du film de conversion photoélectrique organique (40).

4. Capteur d'image à semi-conducteur selon la revendication 1, dans lequel la structure d'isolation (13) est également disposée entre les segments de filtre à couleur (20SR, 20SW ou 20SB), et la structure d'isolation (13) est en outre disposée entre les segments organiques (40S).

5. Capteur d'image à semi-conducteur selon l'une quelconque des revendications précédentes, dans lequel les nanostructures (60U) sont disposées sur un côté supérieur de l'électrode supérieure (50U).

6. Capteur d'image à semi-conducteur selon l'une quelconque des revendications précédentes, dans lequel l'électrode inférieure (50L) a des segments d'électrode (50LS) correspondant aux éléments de conversion photoélectrique (11R, 11Mg, 11B), et/ou l'un des segments d'électrode (50LS) comporte un premier segment d'électrode (50LS1) et un second segment d'électrode (50LS2) qui correspondent à l'un des segments de filtre à couleur (20SR, 20SW ou 20SB).

7. Capteur d'image à semi-conducteur selon la revendication 6, dans lequel une longueur du premier segment d'électrode (50LS1) est différente d'une longueur du second segment d'électrode (50LS2).

8. Capteur d'image à semi-conducteur selon la revendication 6 ou 7, dans lequel le film de conversion photoélectrique organique (40) a des segments organiques (40S), et le premier segment d'électrode (50LS1) et le second segment d'électrode (50LS2) sont disposés sur un côté inférieur d'un segment organique spécifique des segments organiques (40S).

9. Capteur d'image à semi-conducteur selon la revendication 8, dans lequel une longueur des nanostructures (60U, 60L) dans le segment organique spécifique correspond à une longueur du premier segment d'électrode (50LS1).

10. Capteur d'image à semi-conducteur selon l'une quelconque des revendications précédentes, dans lequel les nanostructures (60U, 60L) sont une partie de l'électrode supérieure (50U) ou de l'électrode inférieure (50L).

11. Capteur d'image à semi-conducteur selon l'une quelconque des revendications précédentes, dans lequel chacune des nanostructures (60U, 60L) est formée avec une forme parmi une pyramide triangulaire, un cône et une pyramide quadrangulaire.

12. Capteur d'image à semi-conducteur selon l'une quelconque des revendications précédentes, dans lequel les nanostructures (60U, 60L) comportent un matériau conducteur transparent ou un métal.

13. Capteur d'image à semi-conducteur selon l'une quelconque des revendications précédentes, comportant en outre une structure de condensation (70) disposée sur le film de conversion photoélectrique organique (40), dans lequel la structure de condensation (70) comporte des microlentilles (70m) qui correspondent aux segments de filtre à couleur (20SR, 20SW ou 20SB).
